# EUROPÄISCHE PATENTSCHRIFT

(11) **EP 0 492 193 B1**
(45) Veröffentlichungstag und Bekanntmachung des Hinweises auf die Patenterteilung: **01.06.1994**
(21) Anmeldenummer: 91120798.3
(22) Anmeldetag: 04.12.1991
(51) Int. Cl.: B23P 19/02

(54) **Verfahren und Vorrichtung zum Einbringen eines Stiftes in eine dünne Platte**
Method and device for inserting a pin in a thin plate
Procédé et appareil pour insérer une broche dans une plaque mince

(30) Priorität: 22.12.1990 DE 4041513
(43) Veröffentlichungstag der Anmeldung: 01.07.1992
(73) Patentinhaber: UMFORMTECHNIK BENDER GMBH & CO. KG, D-35444 Biebertal (DE)
(72) Erfinder: Irmler, Egon, W-6301 Pohlheim 4/OT Holzheim (DE); Bender, Jürgen, W-6301 Biebertal (DE)
(74) Vertreter: Knefel, Siegfried, Dipl.-Math.

(56) Entgegenhaltungen:
- DE-A- 3 722 587
- US-A- 4 858 289
- PATENT ABSTRACTS OF JAPAN vol. 15, no. 279 (M-1136)16. Juli 1991 & JP-A-3098726 (HITACHI LTD) 24 April 1991
- IBM TECHNICAL DISCLOSURE BULLETIN Bd. 20, Nr. 7, Dezember 1977, NEW YORK USASeiten 2616 - 2618; L. D. HOUSE & R. C.STEELE: 'Automated pin assembly system'
- PATENT ABSTRACTS OF JAPAN vol. 10, no. 311 (M-528)(2367) 23. Oktober 1986 & JP-A-61 121 839 (MATSUSHITA ELECTRIC IND CO LTD) 9 Juni 1986

## Beschreibung

Die Erfindung betrifft ein Verfahren sowie eine Vorrichtung zum Einbringen eines Stiftes in eine dünne Platte. Nach den bekannten Verfahren werden in die Platten Löcher gestanzt und in diese Löcher die einzelnen Stifte eingeführt. Die Stifte sollen hierbei in den Löchern einen festen Halt haben, da sie beispielsweise beim Zusammenbau von Geräten als Drehlager für andere Teile dienen, aber auch als Führungsstifte für Kurventeile, welche anderen Teile bestimmte Bewegungen aufzwingen. Derartige Stiftanordnungen in Platten werden beispielweise bei Rundfunkgeräten, insbesondere in Autoradios, in großer Zahl verwendet. Das Plattenmaterial weist hierbei eine Stärke von 0,5 mm bis 2,0 mm auf.

Nach dem Stand der Technik (siche z.B. Patent Abstracts of Japan vol. 10, no 311 (M-528)(2367) & JP-A-61121839) werden in die Platten die erforderlichen Löcher gestanzt und die Stifte in oder durch die Löcher gedrückt. Damit die Stifte in den Löchern nach dem Einbringen einen festen Halt haben, werden die Durchmesser der Löcher etwas kleiner gehalten als der Durchmesser der Stifte, so daß diese sich klemmend in die Löcher pressen. Diese Ausbildung befriedigt nicht, da bei diesem Verfahren stets eine Lockerung der Stifte in den Löchern zu befürchten ist, entweder aus Gründen auftretender Fertigungstoleranzen, oder auch infolge von Temperaturschwankungen. Nicht zuletzt werden auf die Stifte ständig seitliche Belastungen ausgeübt. Da die Platten darüber hinaus recht dünn sind, können die Stifte leicht aus ihren Löchern ausbrechen.

Da die genannten Geräte in großer Stückzahl hergestellt werden, demzufolge auch die Platten, welche die Stifte tragen, und da in die Platten nicht nur ein Stift eingebracht werden soll, sondern eine große Zahl von Stiften, muß eine Sicherheit dafür gegeben sein, daß jeder der Stifte in der Platte einen festen Halt hat und seine Aufgabe wahrnehmen kann.

Aufgabe der Erfindung ist es, ein Verfahren zum Einbringen von Stiften in dünne Platten anzugeben, sowie eine Vorrichtung zur Durchführung des Verfahrens, welches sich maschinell durchführen läßt und es gestattet, eine Vielzahl von Stiften in eine Vielzahl von Stanzteilen so einzubringen, daß sämtliche Stifte eine sichere Lage in den Platten aufweisen.

Diese Aufgabe wird durch das Verfahren des Anspruches 1 gelöst, sowie durch die Vorrichtung nach dem Anspruch 14.

Dadurch, daß jetzt in sukzessiver Folge auch noch miteinander verbundene Platten schrittweise die Vorrichtung durchlaufen und die Vorrichtung so viele hintereinanderliegende Arbeitsstationen aufweist, wie Arbeitsgänge nach dem Anspruch 1 durchgeführt werden sollen, wird dann, wenn die erste Platte die erste Arbeitsstelle erreicht, für diese Platte der erste Arbeitsgang durchgeführt, das heißt also, an den Stellen der einzubringenden Stifte wird eine Vorverdichtung vorgenommen. Anschließend wird in der zweiten Arbeitsstation der zweite Arbeitsgang durchgeführt und so fort. Hat die Platte die letzte Arbeitsstation erreicht, wird der abschließende Meßvorgang als Kontrollvorgang durchgeführt. Inzwischen wurden in den folgenden Platten die vorangehenden Arbeitsgänge von Stufe zu Stufe durchgeführt, so daß ein sukzessiver Ausstoß von mit Stiften versehenen Platten erfolgt.

Durch das Vorpressen der Stelle, an dem der Stift eingebracht werden soll, findet eine Materialverdichtung statt, welche dazu führt, daß der Stift nach dem Einbringen einen sicheren Halt in dem Stanzloch findet, weil nach dem Einbringen des Stiftes im verdichteten Bereich ein Rekristallisation der verdichteten Moleküle erfolgt, welche einen bleibenden Druck auf den Stift ausübt. Auch das Einprägen des Lochrandes unter Gegendruck trägt hierzu bei. Mit anderen Worten, die Stifte lassen sich gemäß der Erfindung relativ leicht in die Löcher der Platte einbringen und sie bleiben in der Platte unverrückbar fest auch bei größeren Belastungen.

Weitere Einzelheiten der Erfindung können den Unteransprüchen entnommen werden.

Auf der Zeichnung ist ein Ausführungsbeispiel der Erfindung dargestellt, und zwar zeigen:
- Fig. 1: eine schematische Darstellung des Verfahrensablaufes;
- Fig. 2: eine Einzelheit der Fig. 1;
- Fig. 3: die Draufsicht auf die Fig. 2.

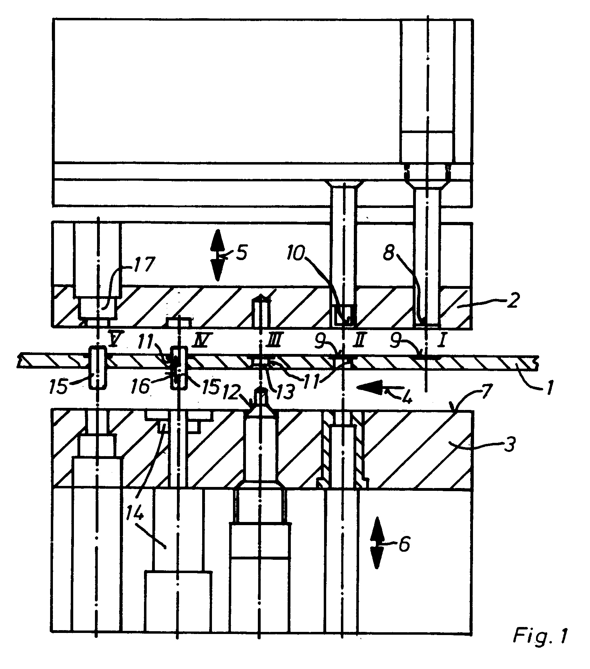

Gemäß Fig. 1 wird eine Platte (1) zwischen zwei Werkzeugteilen (2, 3) schrittweise in Richtung des Pfeiles (4) hindurchgeschoben. Die Teile (2, 3) bilden ein Folgewerkzeug mit den Arbeitsstationen (I, II, III, IV und V).

Die Werkzeugteile (2, 3) sind für die Auslösung der einzelnen Arbeitsgänge in den Stationen I bis V in Richtung der Pfeile (5, 6) gegeneinander preßbar und anschließend wieder auseinanderbewegbar, so daß die Platte (1) um einen Arbeitsschritt in Richtung des Pfeiles (4) weiterbewegt werden kann.

In der Arbeitsstation (I) wird der untere Werkzeugteil (3) angehoben, so daß die Platte (1) fest auf dessen Oberfläche (7) aufliegt. Von oben her wird mit Hilfe eines Stempels (8) das Plattenmaterial an der Stelle des einzubringenden Stiftes verdichtet. Die Verdichtung ist durch eine kleine Delle (9) angedeutet. Die Werkzeugteile (2, 3) werden nunmehr wieder auseinanderbewegt und die Platte einen Schritt nach links verschoben, so daß die eingebrachte Delle (9) in die Arbeitsstation (II) einfährt. An dieser Stelle wird mit Hilfe eines Stanzteiles (10) ein Loch (11) durch die Platte (1) gestoßen. Der Durchmesser des Loches (11) ist kleiner als die Zone (Delle (9)) des verdichteten Plattenmaterials.

Ist dieser Vorgang durchgeführt, wird die Platte in Richtung des Pfeiles (4) weiterbewegt, bis sich das Loch (11) in der Arbeitsstation (III) befindet. Die Werkzeugteile (2, 3) werden jetzt wieder zusammengeführt, so daß sie oben und unten fest auf der Platte liegen und von unten her wird mit Hilfe eines Prägewerkzeuges (12) der untere Lochrand (13) kegelförmig angedrückt, so daß der Stift von hier aus in das Loch (11) geschoben werden kann. Bei diesem Anprägen wird gleichzeitig in etwaiger Grat, welcher durch das Stanzen entstanden ist, angepreßt. Außerdem erfolgt eine erneute, zusätzliche Verdichtung des Materials im Bereich des Loches (11).

Die Platte wird nunmehr wiederum einen Schritt weiterbewegt, so daß das Loch (11) in die Arbeitsstation (IV) einfährt. In dieser Station wird von unten her mit Hilfe einer noch zu beschreibenden Zubringereinrichtung (14) der Stift (15) in Richtung des Pfeiles (16) durch das Loch (11) gedrückt. Das Durchdrücken kann so weit erfolgen, daß der Stift mit seinem größeren Ende oben aus der Platte herausragt, oder aber auch mit seinem längeren Ende unten verbleibt.

Nunmehr wird die Platte (1) wiederum einen Schritt weiter geführt, so daß der Stift (15) in die Arbeitsstation (V) einfährt. An dieser Stelle wird mit Hilfe einer Meßeinrichtung (17) die Lage des Stiftes (15) in und/oder auf der Platte kontrolliert.

Bei jedem Zusammenpressen der Werkzeuge (2, 3) wird in den Arbeitsstationen (I bis V) der dieser Station zugeordnete Arbeitsgang durchgeführt, so daß in sukzessiver Folge Platten (1) mit exakt eingebrachten Stiften (15) ausgestoßen werden.

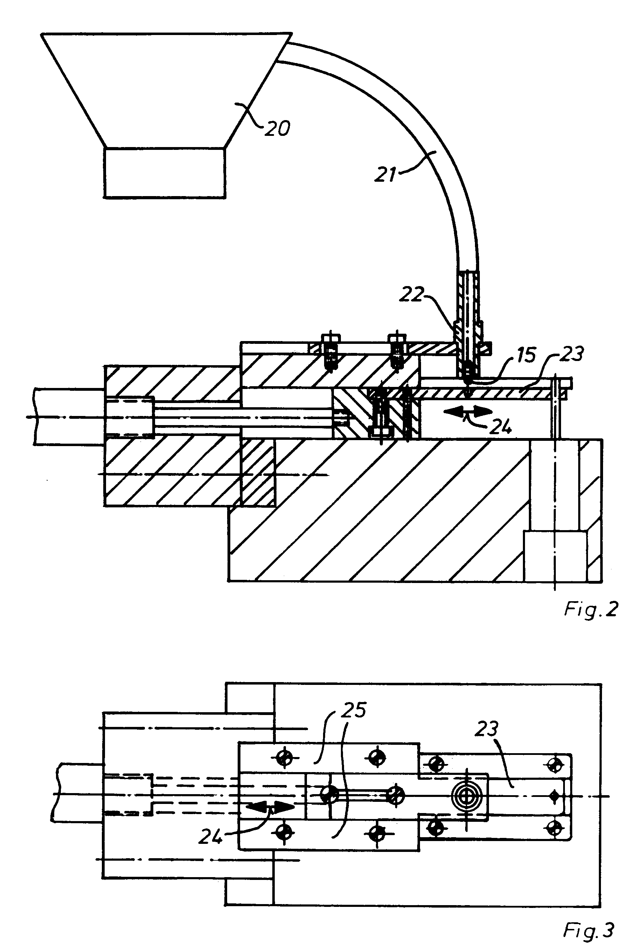

Gemäß den Fig. 2 und 3 werden die Stifte (15) aus einem Rütteltopf (20) über eine Staustrecke (21) dem Ladewerkzeug (22) zugeführt, das sie auf einer Unterlage (23), welche entsprechende Ausnehmungen trägt, senkrecht angeordnet ablegt. Die Unterlage (23) ist als Schlitten ausgebildet und in Richtung des Pfeiles (24) verschiebbar, so daß nach dem Ablegen des Stiftes (15) auf der Unterlage (23) diese nach links bewegt werden kann. Der Stift wird hierdurch in der Arbeitsstation (IV) der Fig. 1 unter das Loch (11) gefahren und von hier aus durch Anheben des Werkzeugteiles (3) und Absenken des Werkzeugteiles (2) zur Erzeugung eines entsprechenden Gegendruckes in das Loch (11) eingeschoben. Die Unterlage (23) läuft hierzu in entsprechenden Führungen (25). Anschließend wird die Unterlage zurückbewegt, um einen neuen Stift (15) aufzunehmen.

Das Einbringen des Stiftes unter Gegendruck erfolgt also sozusagen im Bereich des unteren Totpunktes. Dies bedeutet, daß der Stift in dem Moment in das Loch der Platte eingebracht wird, in dem das Werkzeug auf Enddruck gefahren ist.

## Patentansprüche

1. Verfahren zum Einbringen eines Stiftes in eine dünne Platte (Stanzteil), bei dem an der Stelle des einzubringenden Stiftes in die Platte ein Loch gestanzt und der Stift in das Loch eingebracht wird,
**dadurch gekennzeichnet,** daß an der Stelle des einzubringenden Stiftes (15) das Plattenmaterial verdichtet wird,
daß anschließend an dieser Stelle (Delle (9)) das Loch (11) in die Platte (1) gestanzt wird,
daß von der Seite des einzubringenden Stiftes (15) her der Rand (13) des Loches (11) unter Gegendruck konisch erweitert (eingeprägt) wird,
daß in der Achse des Loches (11) unterhalb der Platte (1) der Stift (15) aufrecht stehend angeordnet wird,
daß anschließend durch Anheben des Stiftes (15) oder Absenken der Platte (1) der Stift (15) wenigstens teilweise durch das Loch (11) getrieben wird,
und daß die Durchschubgröße des Stiftes (15) durch das Loch (11), gegebenenfalls die Lage des Stiftes auf der Platte (1), gemessen wird.

2. Verfahren nach Anspruch 1, dadurch gekennzeichnet, daß das Verdichten des Materials durch Ausüben eines Druckes auf die Platte (1) im Bereich des zu stanzenden Loches (11) erfolgt.

3. Verfahren nach Anspruch 1, dadurch gekennzeichnet, daß die Verdichtungsfläche (Delle (9)) größer als das auszustanzende Loch (11) ist.

4. Verfahren nach Anspruch 2, dadurch gekennzeichnet, daß der Verdichtungsdruck von beiden Seiten her auf die Platte (1) ausgeübt wird.

5. Verfahren nach Anspruch 2, dadurch gekennzeichnet, daß der Druck entgegengesetzt zur Eindringrichtung des Stiftes (15) auf die Platte (1) ausgeübt wird.

6. Verfahren nach Anspruch 1, dadurch gekennzeichnet, daß die Einprägung des Lochrandes (13) sich kegelförmig erweiternd zum Plattenrand hin ausläuft.

7. Verfahren nach Anspruch 1, dadurch gekennzeichnet, daß der Stift (15) aufrecht stehend auf einer Zuführeinrichtung (14) (Schlitten) abgelegt wird, daß der Stift (15) mit Hilfe der Zuführeinrichtung unter das Stanzloch (11) gefahren wird und der Stift (15) durch Absenken der Platte (1) oder Anheben des Stiftes (15) in oder durch das Loch (11) gedrückt wird.

8. Verfahren nach Anspruch 1, dadurch gekennzeichnet, daß der Stift bei einem auf die Platte (1) ausgeübten Gegendruck durch das Loch gepreßt wird.

9. Verfahren nach Anspruch 1, dadurch gekennzeichnet, daß der Stift (15) nach seinem Durchschieben durch das Loch (11) mit einem Ende geringfügig aus der Platte (1) herausragt.

10. Verfahren nach Anspruch 1, dadurch gekennzeichnet, daß die aus der Platte (1) herausragende Länge des Stiftes (15) auf einer der Plattenseiten gemessen wird.

11. Verfahren nach Anspruch 10, dadurch gekennzeichnet, daß die auf der Ausschubseite entstandene Länge des Stiftes (15) gemessen wird.

12. Verfahren nach Anspruch 1, dadurch gekennzeichnet, daß das Plattenmaterial ein Metall ist.

13. Verfahren nach Anspruch 1, dadurch gekennzeichnet, daß das Stiftmaterial ein Metall ist.

14. Vorrichtung zur Durchführung des Verfahrens nach Anspruch 1, dadurch gekennzeichnet, daß mehrere hintereinanderliegende Bearbeitungsstellen (I bis V) für die Durchführung der einzelnen Bearbeitungsvorgänge im festen Abstand voneinander vorgesehen sind, an denen die Platte (1) stufenweise vorbeibewegbar ist nämlich:
Station I für die Verdichtung des Plattenmateriales an der Stelle des einzubringenden Stiftes (15),
Station II für das Stanzen des Loches (11) in die Platte (1) an der Stelle des einzubringenden Stiftes (Delle 9),
Station III für die konische Erweiterung des Randes (13) des Loches (11),
Station IV für das Einbringen des Stiftes (15) in das Loch (11) sowie
Station V für, die Messung der Durchschubgröße des Stiftes (15) durch das Loch (11) auf der Platte (1) und gegebenenfalls der Lage des Stiftes (15) auf der Platte (1).

15. Vorrichtung nach Anspruch 14, gekennzeichnet durch ein unteres (3) und ein oberes (2) aufeinanderzubewegbares Werkzeugteil, und daß die Werkzeugteile (2, 3) beim Zusammenführen an sämtlichen Bearbeitungsstellen (I bis V) gleichzeitig den ihnen zugewiesenen Arbeitsgang durchführen.

16. Vorrichtung zur Durchführung des Verfahrens nach Anspruch 7, dadurch gekennzeichnet, daß der Schlitten (Zuführeinrichtung (14)) Bestandteil des unteren Werkzeugteiles (3) ist.

17. Vorrichtung nach Anspruch 16, dadurch gekennzeichnet, daß der Schlitten (Zuführeinrichtung (14)) in einer Ausnehmung des unteren Werkzeugteiles (3) einschiebbar ist.

18. Verfahren nach Anspruch 1, dadurch gekennzeichnet, daß die Platte (1) (Stanzteil) etwa horizontalliegend zu den Werkzeugteilen (2, 3) hindurchbewegt wird, daß die Materialverdichtung von oben her erfolgt, daß der Stanzvorgang von oben her erfolgt, daß das Einprägen des Lochrandes von unten her erfolgt, daß das Einbringen des Stiftes (15) in das Loch (11) von unten her erfolgt, und daß die Messung der Durchschubgröße, gegebenenfalls die Lage des Stiftes auf der Platte, von oben her erfolgt.

19. Verfahren nach Anspruch 1, dadurch gekennzeichnet, daß die Zufuhr und Ablage des Stiftes (15) auf dem Schlitten von oben her erfolgt.

20. Verfahren nach Anspruch 1, gekennzeichnet durch das gleichzeitige Einbringen einer Vielzahl von Stiften in eine Platte.

## Claims

1. Method for inserting a pin in a thin plate (punched part) in which a hole is punched into the plate at the location of the pin which is to be inserted and the pin is inserted in the hole,
**characterized in that** the plate material is compressed at the location of the pin (15) which is to be inserted,
that the hole (11) is punched into the plate (1) at this location (depression (9)),
that the edge (13) of the hole (11) is conically expanded (impressed) under counter-pressure from the side of the pin (15) which is to be inserted,
that the pin (15) is positioned upright in the axis of the hole (11) below the plate (1),
that the pin (15) is then driven at least partially through the hole (11) by raising the pin (15) or lowering the plate (1),
and that the push-through dimension of the pin (15) Through the hole (11), where applicable the position of the pin on the plate (1), is measured.

2. Method according to claim 1, characterized in that the compression of the material is induced by exerting a pressure on the plate (1) in the region of the hole (11) which is to be punched.

3. Method according to claim 1, characterized in that the compression area (depression (9)) is larger than the hole (11) which is to be punched.

4. Method according to claim 2, characterized in that the compression pressure is exerted from both sides onto the plate (1).

5. Method according to claim 2, characterized in that the pressure is exerted onto the plate (1) counter to the direction of penetration of the pin (15).

6. Method according to claim 1, characterized in that the impressing of the edge (13) of the hole widens conically towards the edge of the plate.

7. Method according to claim 1, characterized in that the pin (15) is deposited upright on a feeding device (14) (slide), that the pin (15) is moved to below the punched hole (11) by means of the feeding device and the pin (15) is pressed into or through the hole (11) by lowering the plate (1) or raising the pin (15).

8. Method according to claim 1, characterized in that the pin (15) is pressed through the hole by a counter-pressure exerted on the plate (1).

9. Method according to claim 1, characterized in that the pin (15) projects slightly out of the plate (1) with one end after being pushed through the hole (11).

10. Method according to claim 1, characterized in that the length of the pin (15) projecting out of the plate (1) is measured on one of the sides of the plate.

11. Method according to claim 10, characterized in that the length of the pin (15) which has resulted on the push-out side is measured.

12. Method according to claim 1, characterized in that the plate material is a metal.

13. Method according to claim 1, characterized in that the pin material is a metal.

14. Device for performing the method according to claim 1, characterized in that several machining locations (I to V) positioned one behind the other are provided for the performance of the individual machining operations at a fixed distance from one another, by which the plate (1) can be moved step by step, viz.:
station I for the compression of the plate material at the location of the pin (15) which is to be inserted,
station II for the punching of the hole (11) into the plate (1) at the location (depression (9)) of the pin which is to be inserted,
station III for the conical expansion of the edge (13) of the hole (11),
station IV for the insertion of the pin (15) in the hole (11) and
station V for the measuring of the push-through dimension of the pin (15) through the hole (11) on the plate (1) and, where applicable, the position of the pin (15) on the plate (1).

15. Device according to claim 14, characterized by a lower (3) and an upper (2) tool part which can be moved towards each other and in that the tool parts (2, 3), on being brought together, perform the machining operation assigned to them simultaneously at all machining locations (I to V).

16. Device for performing the method according to claim 7, characterized in that the slide (feeding device (14)) is an integral part of the lower tool part (3).

17. Device according to claim 16, characterized in that the slide (feeding device (14)) can be pushed in a recess of the lower tool part (3).

18. Method according to claim 1, characterized in that the plate (1) (punched part) is moved through to the tool parts (2, 3) in an approximately horizontal position, that the material compression takes place from above, that the punching operation takes place from above, that the impressing of the edge of the hole takes place from below, that the insertion of the pin (15) in the hole (11) takes place from below, and that the measuring of the push-through dimension, where applicable the position of the pin on the plate, takes place from above.

19. Method according to claim 1, characterized in that the feeding and depositing of the pin (15) on the slide is carried out from above.

20. Method according to claim 1, characterized by the simultaneous insertion of a large number of pins in a plate.

## Revendications

1. Procédé pour insérer une broche dans une plaque mince (pièce découpée), selon lequel à l'emplacement de la broche à insérer, on perce un trou dans la plaque et on insère la broche dans le trou,
caractérisé en ce
qu'on comprime le matériau de la plaque à l'emplacement de la broche (15) devant être insérée,
qu'ensuite on découpe le trou (11) dans la plaque (1) en cet emplacement (partie déformée (9)),
qu'on élargit avec une forme conique (par gaufrage en creux), sous l'action d'une contre-pression, le bord (13) du trou (11) à partir du côté de la broche (15) devant être insérée,
que sur l'axe du trou (11), on dispose verticalement la broche (15) au-dessous de la plaque (1),
qu'ensuite en soulevant la broche (15) ou en abaissant la plaque (1), on introduit la broche (15) au moins partiellement dans le trou (11), et
qu'on mesure la longueur d'enfoncement de la broche (15) dans le trou (11), et éventuellement la position de la broche sur la plaque (1).

2. Procédé selon la revendication 1, caractérisé en ce que la compression du matériau est mise en oeuvre par application d'une pression à la plaque (1) dans la zone du trou (11) devant être découpé.

3. Procédé selon la revendication 1, caractérisé en ce que la surface d'étanchéité (partie déformée (9)) est plus étendue que le trou (11) devant être découpé.

4. Procédé selon la revendication 2, caractérisé par le fait que la pression de la compression est appliquée des deux côtés à la plaque (1).

5. Procédé selon la revendication 2, caractérisé en ce que la pression est appliquée à la plaque (1), en sens opposé de la direction d'introduction de la broche (15).

6. Procédé selon la revendication 1, caractérisé en ce que le gaufrage en creux du bord du trou (13) s'étend avec une forme conique élargie en direction du bord de la plaque.

7. Procédé selon la revendication 1, caractérisé en ce qu'on place la broche (15) verticalement sur un dispositif d'amenée (14) (chariot), qu'on amène la broche (15) à l'aide du dispositif d' amenée au-dessous du trou découpé (11) et qu'on repousse la broche (15) par abaissement de la plaque (1) ou soulèvement de la broche (15) dans ou à travers le trou (11).

8. Procédé selon la revendication 1, caractérisé en ce que dans le cas où une contre-pression est appliquée à la plaque (1), on enfonce la broche dans le trou.

9. Procédé selon la revendication 1, caractérisé en ce qu'après avoir traversé le trou (11), la broche (15) ressort légèrement, par une extrémité, hors de la plaque (1).

10. Procédé selon la revendication 1, caractérisé en ce qu'on mesure la longueur de la broche (15), qui fait saillie hors de la plaque (1), sur l'une des faces de cette plaque.

11. Procédé selon la revendication 10, caractérisé en ce qu'on mesure la longueur de la broche (15), qui ressort sur le côté sortie.

12. Procédé selon la revendication 1, caractérisé en ce que le matériau de la plaque est un métal.

13. Procédé selon la revendication 1, caractérisé en ce que le matériau de la broche est un métal.

14. Dispositif pour la mise en oeuvre du procédé selon la revendication 1, caractérisé par le fait que plusieurs postes de traitement (I à V), sont disposés les uns derrière les autres à une distance réciproque fixe, pour la mise en oeuvre des différentes opérations de traitement, postes auxquels la plaque (1) peut être amenée de façon progressive, à savoir :
poste I pour la compression du matériau de la plaque à l'emplacement de la broche (15) devant être insérée,
poste II pour le découpage du trou (11) dans la plaque (1) à l'emplacement de la broche devant être introduite (partie déformée 9),
poste III pour l'élargissement conique du bord (13) du trou (11),
poste IV pour l'introduction de la broche (15) dans le trou (11), et
poste V pour la mesure de la longueur d'insertion de la broche (15) à travers le trou (11) dans la plaque (1), et éventuellement dans la position de la broche (15) sur la plaque (1).

15. Dispositif selon la revendication 14, caractérisé par une partie inférieure d'outil (3) et une partie supérieure d'outil (2), pouvant être rapprochées l'une de l'autre et par le fait que, lorsqu'elles sont réunies dans tous les postes de traitement (I à V), les parties d'outil (2, 3) exécutent simultanément l'étape opératoire qui leur est affectée.

16. Dispositif pour la mise en oeuvre du procédé selon la revendication 7, caractérisé en ce que le chariot (dispositif d'amenée (14)) fait partie de la partie inférieure d'outil (3).

17. Dispositif selon la revendication 16, caractérisé en ce que le chariot (dispositif d'amenée (14)) peut être inséré dans un évidement de la partie inférieure d'outil (3).

18. Procédé selon la revendication 1, caractérisé en ce que la plaque (1) (pièce découpée) peut être déplacée en position approximativement horizontale jusqu'aux parties d'outil (2, 3), que la compression du matériau s'effectue à partir du haut, que l'opération de découpage s'effectue à partir du haut, que la formation par gaufrage en creux du bord du trou s'effectue à partir du bas, que l'insertion de la broche (15) dans le trou s'effectue à partir du bas, et que la mesure de la longueur d'enfoncement et éventuellement de la position de la broche sur la plaque, s'effectue à partir du haut.

19. Procédé suivant la revendication 1, caractérisé en ce que l'amenée et le dépôt de la broche (15) sur le chariot s'effectue à partir du haut.

20. Procédé suivant la revendication 1, caractérisé par la position simultanée d'une multiplicité de broches dans une plaque.
